(19) Europäisches Patentamt
European Patent Office
Office européen des brevets

(11) **EP 3 963 702 B1**

(12) **EUROPÄISCHE PATENTSCHRIFT**

(45) Veröffentlichungstag und Bekanntmachung des Hinweises auf die Patenterteilung:
**07.01.2026 Patentblatt 2026/02**

(21) Anmeldenummer: **20723109.3**

(22) Anmeldetag: **29.04.2020**

(51) Internationale Patentklassifikation (IPC):
*H02M 1/38* (2007.01)  *H02P 27/08* (2006.01)
*H02M 7/5387* (2007.01)  *B62D 5/04* (2006.01)
*G01R 29/02* (2006.01)

(52) Gemeinsame Patentklassifikation (CPC):
**H02M 1/38; B62D 5/0484; B62D 5/0487;**
**G01R 29/02; H02M 7/5387; H02P 27/08;**
**H02M 1/385**

(86) Internationale Anmeldenummer:
**PCT/EP2020/061929**

(87) Internationale Veröffentlichungsnummer:
**WO 2020/225059 (12.11.2020 Gazette 2020/46)**

(54) **VERFAHREN ZUM MESSEN DER TOTZEIT VON LEISTUNGSSCHALTERN UND KFZ-SERVOLENKUNG DIE DAS VERFAHREN AUSFÜHRT**

METHOD FOR MEASURING THE DEAD TIME OF CIRCUIT BREAKERS AND AUTOMOBILE POWER STEERING SYSTEM USING THE METHOD

PROCÉDÉ DE MESURE DU TEMPS MORT D'INTERRUPTEURS DE PUISSANCE ET DIRECTION ASSISTÉE DE VÉHICULE AUTOMOBILE QUI EXÉCUTE CE PROCÉDÉ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **03.05.2019 DE 102019111493**

(43) Veröffentlichungstag der Anmeldung:
**09.03.2022 Patentblatt 2022/10**

(73) Patentinhaber:
• **thyssenkrupp Presta AG**
**9492 Eschen (LI)**

• **thyssenkrupp AG**
**45143 Essen (DE)**

(72) Erfinder: **KALAPOS, Gábor**
**2230 Gyömro (HU)**

(74) Vertreter: **thyssenkrupp Intellectual Property GmbH**
**ThyssenKrupp Allee 1**
**45143 Essen (DE)**

(56) Entgegenhaltungen:
EP-A1- 1 876 693    DE-A1- 102015 115 338
US-A1- 2006 038 545

**Beschreibung**

Die vorliegende Erfindung betrifft ein Verfahren zum Messen der Totzeit von Leistungsschaltern in einer Motor-Endstufe mit den Merkmalen des Anspruchs 1 und eine elektromechanische Kraftfahrzeugservolenkung mit den Merkmalen des Anspruchs 7.

Elektromechanische Lenkungen weisen üblicherweise einen permanent erregten Synchronmotor als Servomotor auf. Servomotoren dieser Bauart werden von einer Steuerung über einen Satz von MOSFETs angesteuert, wobei bei drei Phasenwicklungen insgesamt sechs MOSFETs in drei Halbbrücken vorgesehen sind. Je ein MOSFET schaltet die zugeordnete Phasenwicklung auf die Bordspannung (High-Side) oder das Massepotential (Low-Side). Diese Schaltung erfolgt mit hoher Frequenz, so dass in der Phasenwicklung der zeitliche Mittelwert als Effektivspannung wirkt. Die beiden Schalter in einer Halbbrücke (High- und Low-Side) dürfen nie gleichzeitig geschlossen sein, da sonst die Gleichspannungsquelle kurzgeschlossen würde. Es ist daher eine Wartezeit zwischen den Schaltvorgängen vorgesehen, die sogenannte Totzeit. Nachdem der betreffende Schalter den Befehl zum Öffnen erhalten hat, wird eine bestimmte Zeit gewartet. Erst dann erhält der komplementäre Schalter den Befehl zum Schließen.

Aus EP 1 876 693 A1 ist ein Verfahren zum Ansteuern einer Transistorhalbbrücke bekannt, deren Treiberschaltung einen programmierbaren Verzögerungsschaltkreis zur dynamischen Einstellung einer Verzögerungszeit zwischen zwei Treiber-Ausgangssignalen zur Ansteuerung der Transistorschalter der Halbbrücke aufweist. Die Verzögerungszeit wird iterativ solange reduziert bis sich die Phasenverschiebung zwischen einem Steuersignal und dem geschalteten Phasenspannungssignal nicht länger reduziert.

Aus der Offenlegungsschrift DE 10 2015 115 338 A1 ist ein Verfahren zur Ermittlung der Totzeit einer Motor-Endstufe bekannt, bei dem in einem iterativen Prozess die Totzeit um eine Zeiteinheit bis zum Vorliegen eines Kurzschluss verringert wird, um die optimale Totzeit zu bestimmen.

US 2006/0038545 A1 beschreibt eine Treiberschaltung für einen Schaltkreis mit zwei Gatetreibern zum abwechselnden An- und Abschalten zweier in Reihe geschalteter Gatetransistoren und mit einem Überwachungsschaltkreis zum Überwachen der Spannungen an zwei Überwachungspunkten zur Zustandsüberwachung der Gatetransistoren. Der Treiberschaltkreis ist dazu eingerichtet, die Zeit, zu der die Spannung am ersten Überwachungspunkt eine erste vorbestimmte Spannung passiert, und die Zeit, zu der die Spannung an dem Überwachungspunkt eine zweite vorbestimmte Spannung passiert, zu vergleichen und eine Verzögerung zwischen der Ansteuerung der Gatetreiber zum An- bzw. Abschalten jeweils eines der beiden in Reihe geschalteten Gatetransistoren in Abhängigkeit von der Reihenfolge der ermittelten Zeiten zu verringern oder zu erhöhen. Wenn die Verzögerung in zu großen Schritten verringert wird, können sich die Gate-Signale so weit überlappen, dass beide Gatetransistoren voll durchgeschaltet sind und ein "Durchschießen" stattfindet, was die Verluste erhöht. Daher müssen die Schritte klein genug sein, um ein signifikantes Durchschießen zu vermeiden.

Es ist Aufgabe der vorliegenden Erfindung, ein Verfahren zum Messen der Totzeit von Leistungsschaltern in einer Motor-Endstufe anzugeben, das besonders einfach ist und das erlaubt, das Schaltverhalten der einzelnen Leistungsschalter zu überwachen und/oder die Totzeit optimal einzustellen. Diese Aufgabe wird von einem Verfahren mit den Merkmalen des Anspruchs 1 und einer elektromechanischen Kraftfahrzeugservolenkung mit den Merkmalen des Anspruchs 7 gelöst. In den Unteransprüchen sind vorteilhafte Weiterbildungen der Erfindung genannt.

Demnach ist ein Verfahren zum Messen der Totzeit von Leistungsschaltern in einer Motor-Endstufe, vorgesehen, wobei die Motor-Endstufe wenigstens eine Halbbrücke mit einem High-Side-FET und einem Low-Side-FET umfasst und das Verfahren folgende Verfahrensschritte aufweist:

- Messen eines tatsächlichen Einschaltzeitpunkts und eines tatsächlichen Ausschaltzeitpunktes des Low-Side-FETs,

- Messen eines tatsächlichen Einschaltzeitpunkts und eines tatsächlichen Ausschaltzeitpunktes des High-Side-FETs,

- Berechnen der Zeitdauer zwischen einem Ausschaltbefehl des High-Side-FETs und dem tatsächlichen Einschaltzeitpunkt des Low-Side-FETs zur Bestimmung der Einschaltzeit des Low-Side-FETs,

- Berechnen der Zeitdauer zwischen einem Ausschaltbefehl des Low-Side-FETs und dem tatsächlichen Ausschaltzeitpunkt des Low-Side-FETs zur Bestimmung der Ausschaltzeit des Low-Side-FETs,

- Berechnen der Zeitdauer zwischen dem Ausschaltbefehl des Low-Side-FETs und einem tatsächlichen Einschaltzeitpunkt des High-Side-FETs zur Bestimmung der Einschaltzeit des High-Side-FETs,

- Berechnen der Zeitdauer zwischen dem Ausschaltbefehl des High-Side-FETs und dem tatsächlichen Ausschaltzeitpunkt des High-Side-FETs zur Bestimmung der Ausschaltzeit des High-Side-FETs,

- Berechnen der Totzeiten DTF, DTR mit folgender Formel:

DTF= (Einschaltzeit des Low-Side-FET) - (Ausschaltzeit des High-Side-FET), DTR= (Einschaltzeit des High-Side-FET) - (Ausschaltzeit des Low-Side--FET),

- Vergleichen der berechneten Totzeiten (DTF,DTR) mit vorgegebenen Sollwerten.

Die berechneten Totzeiten werden dabei bevorzugt kontinuierlich während des Betriebs gemessen, so dass Fehler im System einfach detektiert werden können. Zudem ist es möglich, die Totzeiten zwischen den Schaltsignalen anzupassen und somit zu optimieren.

Vorzugsweise erfolgt die Messung der Einschalt- und Ausschaltzeitpunkte für positive und negative Werte des durch die Halbbrücke fließenden Stroms. Es werden dann entsprechend die Totzeiten für positive und negative Werte des durch die Halbbrücke fließenden Leistungsstroms berechnet. Die Abhängigkeit der Totzeiten von der Stromgröße und der Stromrichtung können somit erfasst werden.

Erfindungsgemäß werden die Ausschaltzeitpunkte und die Einschaltzeitpunkte im Signalverlauf der entsprechenden Gate-Source-Spannung durch den jeweiligen Beginn des Miller-Plateaus definiert.

Die Zeitmessung der Einschalt- und Ausschaltzeiten erfolgt vorzugsweise mittels Capture-Timer. Diese weisen bevorzugt eine Flankenerkennungsschaltung auf, die die tatsächlichen Ausschalt- und Einschaltzeitpunkte detektiert.

Erfindungsgemäß umfasst das Verfahren noch die folgenden Schritte:

- Bestimmen der Abweichung zwischen den berechneten Totzeiten und den vorgegebenen Sollwerten,

- Falls die Abweichung größer als ein vorbestimmter Wert ist, Generieren eines Fehlersignals und/oder Ändern der Ein- und Ausschaltbefehle zur Ermittlung der Totzeit.

Es ist vorteilhaft, wenn der vorbestimmte Wert für negative und positive Werte der Abweichung vorgegeben ist und insbesondere unterschiedlich ist.

Es kann weiterhin vorgesehen sein, dass auf das Generieren des Fehlersignals wenigstens einer der folgenden Verfahrensschritte folgt:

- Anpassen eines Wartungsintervalls,

- Ausgeben eines Signals an den Fahrer, das Kraftfahrzeug zu stoppen,

- Ausgeben eines Signals an den Fahrer, eine Werkstatt aufzusuchen, und/oder

- Überführen des Lenksystems in einen Fehlermodus.

Weiterhin ist eine elektromechanische Kraftfahrzeugservolenkung umfassend eine mit einem Lenkrad verbundene obere Lenkwelle und eine mit der oberen Lenkwelle über einen Drehstab verbundene untere Lenkwelle, eine Drehmomentsensoreinheit, die ein von dem Fahrer in die obere Lenkwelle eingeleitetes Drehmoment einer Lenkbewegung erfasst, einen Elektromotor zur Unterstützung der Lenkbewegung, und eine Steuereinheit, die in Abhängigkeit von dem gemessenen Drehmoment den Elektromotor ansteuert, vorgesehen. Die Steuereinheit ist dabei dazu ausgebildet, das zuvor beschriebene Verfahren zum Messen der Totzeit von Leistungsschaltern auszuführen.

Vorzugsweise weist die Steuereinheit einen Inverter auf, der dazu eingerichtet ist, Spannungssignale in Phasenströme zur Ansteuerung von drei Motorphasen des Elektromotors umzurechnen, wobei jeder Phasenwindung jeweils eine Halbbrücke zugeordnet ist. Je ein FET schaltet die zugeordnete Phasenwicklung auf die Bordspannung (High-Side) oder das Massepotential (Low-Side). Die Schalter der Halbbrücken sind bevorzugt MOSFETs.

Eine bevorzugte Ausführungsform der Erfindung wird nachfolgend anhand der Zeichnungen näher erläutert. Gleiche bzw. funktionsgleiche Bauteile sind dabei figurübergreifend mit denselben Bezugzeichen versehen. Es zeigen:

Figur 1:  eine schematische Darstellung einer elektromechanischen Hilfskraftlenkung, sowie

Figur 2:  eine Blockschaltung einer Halbbrücke,

Figur 3:     sechs schematische Diagramme mit Signalverläufen, sowie

Figur 4:     drei Diagramme mit gemessenen Signalverläufen.

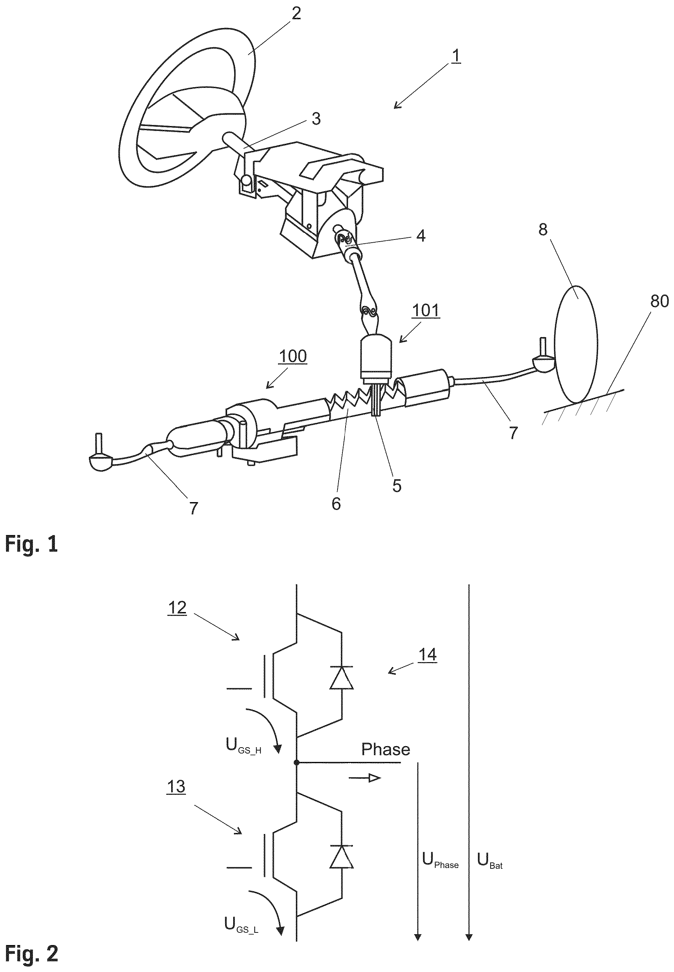

In der Figur 1 ist eine elektromechanische Kraftfahrzeugservolenkung 1 mit einem Lenkrad 2, das mit einer oberen Lenkwelle 3 drehfest gekoppelt ist, schematisch dargestellt. Über das Lenkrad 2 bringt der Fahrer ein entsprechendes Drehmoment als Lenkbefehl in die obere Lenkwelle 3 ein. Das Drehmoment wird dann über die obere Lenkwelle 3 und untere Lenkwelle 4 auf ein Lenkritzel 5 übertragen. Das Ritzel 5 kämmt in bekannter Weise mit einem Zahnsegment einer Zahnstange 6. Die Zahnstange 6 ist in einem Lenkungsgehäuse in Richtung ihrer Längsachse verschieblich gelagert. An ihrem freien Ende ist die Zahnstange 6 mit Spurstangen 7 über nicht dargestellte Kugelgelenke verbunden. Die Spurstangen 7 selbst sind in bekannter Weise über Achsschenkel mit je einem gelenkten Rad 8 des Kraftfahrzeugs verbunden. Eine Drehung des Lenkrades 2 führt über die Verbindung der Lenkwelle 3 und des Ritzels 5 zu einer Längsverschiebung der Zahnstange 6 und damit zu einer Verschwenkung der gelenkten Räder 8. Die gelenkten Räder 8 erfahren über eine Fahrbahn 80 eine Rückwirkung, die der Lenkbewegung entgegen wirkt. Zum Verschwenken der Räder 8 ist folglich eine Kraft erforderlich, die ein entsprechendes Drehmoment am Lenkrad 2 erforderlich macht. Ein Elektromotor 9 einer Servoeinheit 10 ist vorgesehen, um den Fahrer bei dieser Lenkbewegung zu unterstützen. Die obere Lenkwelle 3 und die untere Lenkwelle 4 sind drehelastisch über einen nicht gezeigten Drehstab miteinander gekoppelt. Die drei unterschiedlichen in Figur 1 dargestellten Hilfskraftunterstützungseinrichtungen 10, 100, 101 zeigen alternative Positionen für deren Anordnung. Üblicherweise ist nur eine einzige der gezeigten Positionen mit einer Hilfskraftunterstützung belegt. Die Servoeinheit 10 weist zur Berechnung der Lenkunterstützung eine elektronische Steuereinheit 11 auf. Der Elektromotor 9 verfügt über eine Anzahl an Phasenwindungen. Die Phasenwindungen des Elektromotors werden von der Steuereinheit 11 angesteuert. Die Steuereinheit 11 weist einen Inverter auf, der dazu eingerichtet ist die Spannungssignale in Phasenströme zur Ansteuerung der Motorphasen umzurechnen. Den Phasenwindungen sind jeweils zwei Schaltelemente des Inverters zugeordnet, bevorzugt FETs, insbesondere MOSFETs. Die Schaltelemente sind in drei Halbbrücken angeordnet, die jeweils einen High-Side-FET und einen Low-Side-FET aufweisen.

Figur 2 zeigt die Anordnung eines High-Side-FETs 12 und eines Low-Side-FETs 13 einer Halbbrücke 14. Die High-Side-FETs 12 verbinden die Phasenwindungen mit der Versorgungsspannung $U_{Bat}$ und die Low-Side-FETs 13 stellen eine Verbindung zwischen dem Bezugspotential und den Phasenwindungen her. Dies erfolgt mit hoher Frequenz, so dass in den einzelnen Wicklungen u, v und w der zeitliche Mittelwert als Betriebsspannung $U_{Phase}$ zur Erzeugung eines Unterstützungsmoments wirksam ist. Die High- und Low-Side-FETs 12,13 sind so geschaltet, dass ihre Body-Dioden bezüglich der Bordspannung in Sperrrichtung geschaltet sind. Die FETs 12,13 werden jeweils über eine Steuerleitung mittels eines Gate-Treibers angesteuert. Dazu werden die Steuerelektroden (Gate) der einzelnen FETs mit den erforderlichen Steuersignalen beaufschlagt. Die beiden dargestellten Pfeile symbolisieren die Gate-Source-Spannung $U_{GS}$.

Die beiden Schaltelemente 12,13 in einer Halbbrücke 14 (High- und Low-Side) dürfen nie gleichzeitig geschlossen sein, da sonst die Gleichspannungsquelle kurzgeschlossen würde.

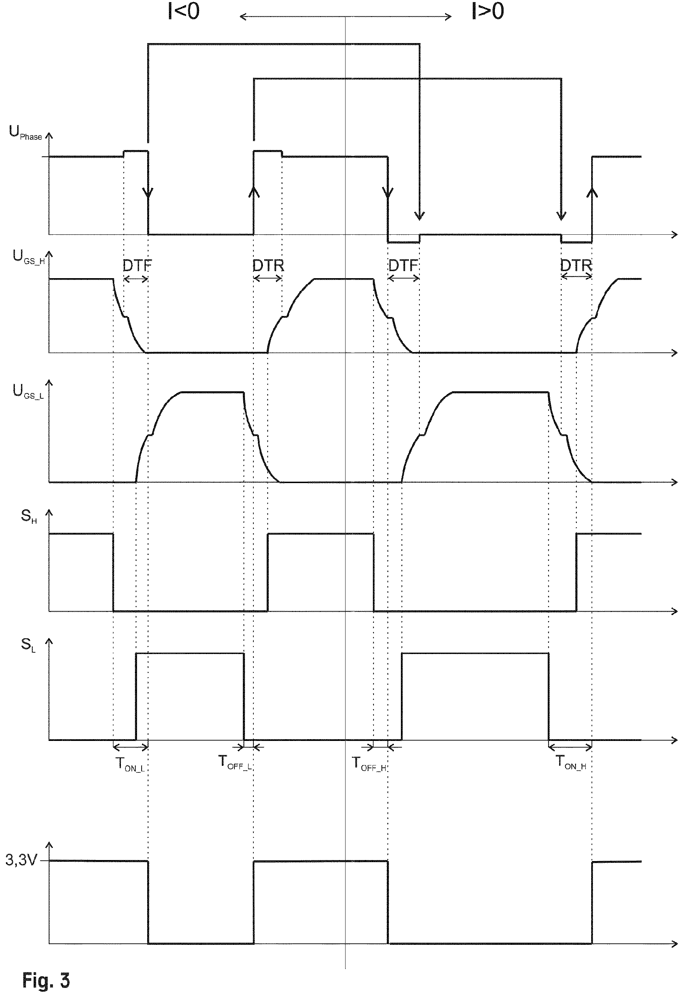

Figur 3 zeigt schematisch zeitliche Signalverläufe der Halbbrücke 14. In der ersten Zeile von oben nach unten ist der zeitliche Verlauf der Phasenspannung $U_{Phase}$ dargestellt. Die zweite Zeile zeigt den zeitlichen Verlauf der Gate-Source-Spannung des High-Side-FET $U_{GS\_H}$ und die dritte Zeile den zeitlichen Verlauf der Gate-Source-Spannung des Low-Side-FET $U_{GS\_L}$. Die vierte Zeile stellt entsprechend das Steuersignal für den High-Side-FET $S_H$ und die fünfte Zeile das Steuersignal für den Low-Side-FET $S_L$ dar. In der letzten Zeile ist der zeitliche Verlauf der Phasenkomponente dargestellt. Die Phasenkomponente gibt den "Zustand" einer bestimmten Phase wieder.

Die Einschaltzeit des Low-Side-FET $T_{ON\_L}$ ist definiert als die Zeitdauer zwischen dem Ausschaltbefehl des High-Side-FETs und dem tatsächlichen Einschaltzeitpunkt des Low-Side-FETs, wobei der Einschaltzeitpunkt per Definition zum Zeitpunkt des Anfangs des Miller-Plateaus liegt.

Die Ausschaltzeit des Low-Side-FET $T_{OFF\_L}$ ist hingegen definiert als die Zeitdauer zwischen dem Ausschaltbefehl des Low-Side-FETs und dem tatsächlichen Ausschaltzeitpunkt des Low-Side-FETs, wobei der Ausschaltzeitpunkt per Definition zum Zeitpunkt des Anfangs des Miller-Plateaus liegt.

Entsprechend ist die Einschaltzeit des High-Side-FET $T_{ON\_H}$ definiert als die Zeitdauer zwischen dem Ausschaltbefehl des Low-Side-FETs und dem tatsächlichen Einschaltzeitpunkt des High-Side-FETs, wobei der Einschaltzeitpunkt per Definition zum Zeitpunkt des Anfangs des Miller-Plateaus liegt.

Die Ausschaltzeit des High-Side-FET $T_{OFF\_H}$ ist definiert als die Zeitspanne zwischen dem Ausschaltbefehl des High-Side-FETs und dem tatsächlichen Ausschaltzeitpunkt des High-Side-FETs, wobei der Ausschaltzeitpunkt per Definition ebenfalls zum Zeitpunkt des Anfangs des Miller-Plateaus liegt.

Die Totzeiten ergeben sich aus den tatsächlichen Ein- und Ausschaltzeitpunkten der nacheinander geschalteten Schalter. Zur Berechnung der Totzeiten werden die Ein- und Ausschaltzeitpunkte der FETs für positive und negative Werte des Leistungsstroms I gemessen, in einem Speicher gespeichert und die Zeitintervalle zwischen den Einschaltzeitpunkten für positive und negative Werte sowie den Ausschaltzeitpunkten für negative und positive Werte verglichen. Die entsprechenden Zeitpunkte und Zeitintervalle des Low-Side-FETs sind in der ersten Zeile durch die beiden oberhalb des Graphs verlaufenden Pfeile angezeigt.

Die Totzeiten ergeben sich durch folgenden Zusammenhang:

DTF= (Einschaltzeit des Low-Side-FET $T_{ON-L}$) - (Ausschaltzeit des High-Side-FET $T_{OFF-H}$),

DTR= (Einschaltzeit des High-Side-FET $T_{ON-H}$) - (Ausschaltzeit des Low-Side-FET $T_{OFF-L}$), wobei DTF für "Totzeit, fallende Flanke der Phasenspannung" und DTR für "Totzeit, steigende Flanke der Phasenspannung" steht. Vorzugsweise sind die Totzeiten DTF sowie die Totzeiten DTR für positive und negative Werte des Leistungsstroms gleich.

Die Schalttransienten sind von der Temperatur und von der Höhe und der Richtung des Stroms I abhängig. Die Zeitdauer zwischen dem Schaltbefehl und dem tatsächlichen Schaltvorgang ändert sich somit während des Betriebs.

Die Zeitmessung der tatsächlichen Einschalt- und Ausschaltzeitpunkte erfolgt mittels Capture-Timer. Ein Capture-Timer hat allgemein die Funktion, ein Intervall eines Auftretens eines externen Eingangssignals zu messen. Als Eingangssignale werden den Capture-Timern die Phasenspannung $U_{phase}$ der FET zugeführt. Die Capture-Timer umfassen eine Flankenerkennungsschaltung, die in der Lage ist, steigende und/oder fallende Flanken des externen Eingangssignals zu erkennen. Die Flankenerkennung triggert die Messung des Intervalls des Auftretens des entsprechenden externen Eingangssignals. Die Flankenerkennungsschaltung ist bevorzugt so eingestellt, dass der Zeitpunkt des Erreichens des Miller-Plateaus als Start- bzw. Stoppsignal gewertet wird. Es werden die Einschalt- und Ausschaltzeitpunkte gemessen.

Die berechneten Totzeiten DTF, DTR werden für alle drei Phasen des Elektromotors bestimmt und mit in vorangegangen Tests ermittelten Sollwerten verglichen. Ist die Abweichung der berechneten Totzeit vom Sollwert größer als ein vorbestimmter Wert, wird die Totzeit bevorzugt iterativ angepasst. Die Abweichung kann dabei eine zu lange Totzeit oder eine zu kurze Totzeit sein. In beide Richtungen ist eine jeweils maximal zulässige Differenz bestimmt, die unterschiedlich sein kann. Die zulässigen Abweichungen werden bei der Auslegung der elektromechanischen Lenkung berechnet bzw. durch Versuche bestimmt.

Das Verfahren kann verwendet werden, um:

- ein Wartungsintervall anzupassen, insbesondere zu verkürzen,

- eine adaptive und iterative Totzeitkompensation vorzunehmen, bei der die Totzeit so gering wie möglich gehalten wird,

- ein Widerstarten des Lenksystem nach einem Stopp bzw. Ausschalten des Systems zu verhindern,

- den Fahrer aufzufordern, das Kraftfahrzeug zu stoppen,

- den Fahrer auf einen Fehler hinzuweisen und/oder aufzufordern, eine Werkstatt aufzusuchen, und/oder

- das Lenksystem in einen Fehlermodus zu überführen. Der Fehlermodus kann beispielswiese nur eine reduzierte Lenkkraftunterstützung, eine reduzierte Lenkgeschwindigkeit und/oder ein reduziertes Lenkmoment bereitstellen.

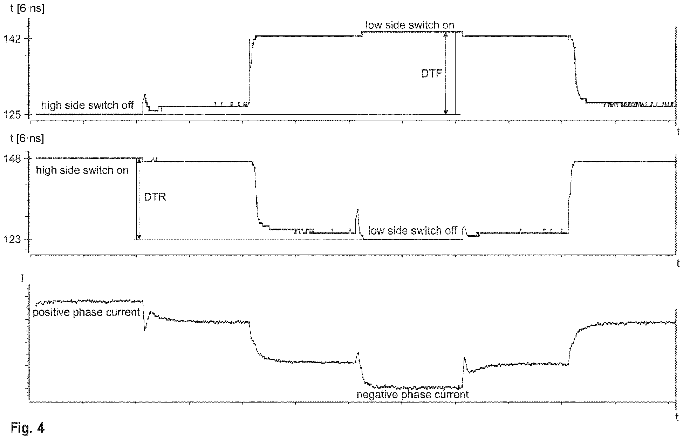

Figur 4 zeigt beispielhaft zeitliche Verläufe der Werte der Schaltzeiten, die mittels Capture-Timer gemessen wurden. In der ersten Zeile von oben nach unten ist die Totzeit der fallenden Flanke (DTF) dargestellt. Auf der y-Achse sind die Schaltzeiten aufgetragen und auf der x-Achse ist die Messdauer aufgetragen. Es wurde für 1 s lang ein kontinuierlicher Wert der Ausschaltzeit des High-Side-FETs von 125 gemessen. Dies entspricht 125*6 ns entsprechend der Skala der y-Achse. Die gemessene Einschaltzeit des Low-Side-FETs beträgt hingegen 142. Die Totzeit der fallenden Flanke (DTF) ergibt sich aus der Differenz der beiden Werte und beträgt somit (142-125)*6 ns= 102 ns.

Die zweite Zeile stellt die Totzeit der steigenden Flanke (DTR) dar. Es wurde für 1 s lang ein kontinuierlicher Wert der Einschaltzeit des High-Side-FETs von 148 gemessen. Dies entspricht 148*6 ns entsprechend der Skala der y-Achse. Die gemessene Ausschaltzeit des Low-Side-FETs beträgt etwa 123. Die Totzeit der steigenden Flanke (DTR) ergibt sich aus der Differenz der beiden Werte und beträgt somit etwa (148-123)*6 ns=150 ns.

In der dritten Zeile ist der zeitliche Verlauf des Stromwertes mit den drei zeitlich hintereinander liegenden Phasen dargestellt.

**Patentansprüche**

1. Verfahren zum Messen der Totzeit von Leistungsschaltern in einer Motor-Endstufe, wobei die Motor-Endstufe wenigstens eine Halbbrücke (14) mit einem High-Side-FET (12) und einem Low-Side-FET (13) umfasst, wobei folgende Verfahrensschritte vorgesehen sind:

- Messen eines tatsächlichen Einschaltzeitpunkts und eines tatsächlichen Ausschaltzeitpunktes des Low-Side-FETs (13),
- Messen eines tatsächlichen Einschaltzeitpunkts und eines tatsächlichen Ausschaltzeitpunktes des High-Side-FETs (12),
- Vergleichen von Totzeiten (DTF,DTR) mit vorgegebenen Sollwerten,
- Bestimmen der Abweichung zwischen den Totzeiten (DTR,DTF) und den vorgegebenen Sollwerten,
- Falls die Abweichung größer als ein vorbestimmter Wert ist, Generieren eines Fehlersignals und/oder Ändern der Ein- und Ausschaltbefehle zur Ermittlung der Totzeit,

**dadurch gekennzeichnet, dass** die Totzeiten mit folgenden Verfahrensschritten berechnet werden:

- Berechnen der Zeitdauer zwischen einem Ausschaltbefehl des High-Side-FETs (12) und dem tatsächlichen Einschaltzeitpunkt des Low-Side-FETs (13) zur Bestimmung der Einschaltzeit des Low-Side-FETs ($T_{ON\_L}$),
- Berechnen der Zeitdauer zwischen einem Ausschaltbefehl des Low-Side-FETs (13) und dem tatsächlichen Ausschaltzeitpunkt des Low-Side-FETs (13) zur Bestimmung der Ausschaltzeit des Low-Side-FETs ($T_{OFF\_L}$),
- Berechnen der Zeitdauer zwischen dem Ausschaltbefehl des Low-Side-FETs (13) und einem tatsächlichen Einschaltzeitpunkt des High-Side-FETs (12) zur Bestimmung der Einschaltzeit des High-Side-FETs ($T_{ON\_H}$),
- Berechnen der Zeitdauer zwischen dem Ausschaltbefehl des High-Side-FETs (12) und dem tatsächlichen Ausschaltzeitpunkt des High-Side-FETs (12) zur Bestimmung der Ausschaltzeit des High-Side-FETs ($T_{OFF\_H}$),
- Berechnen der Totzeiten (DTF,DTR) mit folgender Formel:

DTF= (Einschaltzeit des Low-Side-FET ($T_{ON-L}$)) - (Ausschaltzeit des High-Side-FET ($T_{OFF-H}$)),

DTR= (Einschaltzeit des High-Side-FET ($T_{ON-H}$)) - (Ausschaltzeit des Low-Side-FET ($T_{OFF-L}$)),

wobei die tatsächlichen Ausschaltzeitpunkte und die Einschaltzeitpunkte im Signalverlauf der entsprechenden Gate-Source-Spannung ($U_{GS}$) durch den jeweiligen Beginn des Miller-Plateaus definiert sind.

2. Verfahren nach Anspruch 1, **dadurch gekennzeichnet, dass** das Verfahren die Messung der Einschalt- und Ausschaltzeitpunkte für positive und negative Werte des durch die Halbbrücke fließenden Leistungsstroms (I) umfasst und die Berechnung der Totzeiten entsprechend für positive und negative Werte des durch die Halbbrücke fließenden Leistungsstroms (I) erfolgt.

3. Verfahren nach einem der vorhergehenden Ansprüche, **dadurch gekennzeichnet, dass** die Zeitmessung der Einschalt- und Ausschaltzeiten ($T_{ON-H}$, $T_{ON-L}$, $T_{OFF-H}$, $T_{OFF-L}$) mittels Capture-Timer erfolgt.

4. Verfahren nach Anspruch 3, **dadurch gekennzeichnet, dass** die Capture-Timer eine Flankenerkennungsschaltung aufweisen.

5. Verfahren nach einem der vorhergehenden Ansprüche, **dadurch gekennzeichnet, dass** der vorbestimmte Wert für negative und positive Werte der Abweichung unterschiedlich ist.

6. Verfahren nach einem der vorhergehenden Ansprüche, **dadurch gekennzeichnet, dass** auf das Generieren des Fehlersignals wenigstens einer der folgenden Verfahrensschritte folgt:

- Anpassen eines Wartungsintervalls,
- Ausgeben eines Signals an den Fahrer, das Kraftfahrzeug zu stoppen,
- Ausgeben eines Signals an den Fahrer, eine Werkstatt aufzusuchen, und/oder
- Überführen des Lenksystems in einen Fehlermodus.

7. Elektromechanische Kraftfahrzeugservolenkung umfassend eine mit einem Lenkrad (2) verbundene obere Lenkwelle (3) und eine mit der oberen Lenkwelle (3) über einen Drehstab verbundene untere Lenkwelle (4), eine Drehmomentsensoreinheit, die ein von dem Fahrer in die obere Lenkwelle (3) eingeleitetes Drehmoment einer Lenkbewegung erfasst, einen Elektromotor (9) zur Unterstützung der Lenkbewegung, und eine Steuereinheit (11), die in Abhängigkeit von dem gemessenen Drehmoment den Elektromotor (9) ansteuert, und dazu ausgebildet ist, das Verfahren nach einem der vorhergehenden Ansprüche auszuführen, wobei die Steuereinheit Capture-Timer aufweist, die dazu eingerichtet sind, die tatsächlichen Einschalt- und Ausschaltzeitpunkte zum Zeitpunkt des Erreichens des Miller-Plateaus anhand von steigenden und/oder fallenden Flanken zu messen.

8. Elektromechanische Kraftfahrzeugservolenkung nach Anspruch 7, **dadurch gekennzeichnet, dass** die Steuereinheit (11) einen Inverter aufweist, der dazu eingerichtet ist, Spannungssignale in Phasenströme zur Ansteuerung von drei Motorphasen des Elektromotors (9) umzurechnen, wobei jeder Phasenwindung jeweils eine Halbbrücke (14) zugeordnet ist.

9. Elektromechanische Kraftfahrzeugservolenkung nach Anspruch 7 oder 8, **dadurch gekennzeichnet, dass** die Schalter (12, 13) der Halbbrücken (14) MOSFETs sind.

**Claims**

1. Method for measuring the dead time of power switches in a motor output stage, wherein the motor output stage comprises at least one half-bridge (14) with a high-side FET (12) and a low-side FET (13), wherein the following method steps are provided:

   - Measuring an actual switch-on instant and an actual switch-off instant of the low-side FET (13),
   - Measuring an actual switch-on instant and an actual switch-off instant of the high-side FET (12),
   - Comparing dead times (DTF, DTR) with specified target values,
   - Determining the deviation between the dead times (DTR, DTF) and the specified target values,
   - If the deviation is greater than a predetermined value, generating an error signal and/or changing the switch-on and switch-off commands to determine the dead time, **characterised in that** the dead times are calculated using the following process steps:
   - Calculating the time duration between a switch-off command of the high-side FET (12) and the actual switch-on instant of the low-side FET (13) to determine the switch-on time of the low-side FET ($T_{ON\_L}$),
   - Calculating the time duration between a switch-off command of the low-side FET (13) and the actual switch-off instant of the low-side FET (13) to determine the switch-off time of the low-side FET ($T_{OFF\_L}$),
   - Calculating the time duration between the switch-off command of the low-side FET (13) and an actual switch-on instant of the high-side FET (12) to determine the switch-on time of the high-side FET ($T_{ON\_H}$),
   - Calculating the time duration between the switch-off command of the high-side FET (12) and the actual switch-off instant of the high-side FET (12) to determine the switch-off time of the high-side FET ($T_{OFF\_H}$),
   - Calculating the dead times (DTF, DTR) using the following formula:

   DTF= (switch-on time of the low-side FET ($T_{ON-L}$)) - (switch-off time of the high-side FET ($T_{OFF-H}$)),

   DTR= (switch-on time of the high-side FET ($T_{ON-H}$)) - (switch-off time of the low-side FET ($T_{OFF-L}$)),

   wherein the actual switch-off instants and the switch-on instants are defined in the signal curve of the corresponding gate-source voltage ($U_{GS}$) by the respective onset of the Miller plateau.

2. Method according to claim 1, **characterised in that** the method comprises measuring the switch-on and switch-off instants for positive and negative values of the power current (I) flowing through the half-bridge, and calculating the dead times accordingly for positive and negative values of the power current (I) flowing through the half-bridge.

3. Method according to one of the preceding claims, **characterised in that** the on-time and off-time ($T_{ON-H}$, $T_{ON-L}$, $T_{OFF-H}$, $T_{OFF-L}$) are measured using capture timers.

4. Method according to claim 3, **characterised in that** the capture timers have an edge detection circuit.

5. Method according to one of the preceding claims, **characterised in that** the predetermined value is different for negative and positive values of the deviation.

6. Method according to one of the preceding claims, **characterised in that** the generation of the error signal is followed by at least one of the following method steps:

- adjusting a maintenance interval,
- issuing a signal to the driver to stop the motor vehicle,
- issuing a signal to the driver to visit a workshop, and/or
- placing the steering system to a fault mode.

**7.** Electromechanical motor vehicle power steering comprising an upper steering shaft (3) connected to a steering wheel (2) and a lower steering shaft (4) connected to the upper steering shaft (3) via a torsion bar, a torque sensor unit which detects a torque of a steering movement initiated by the driver in the upper steering shaft (3), an electric motor (9) for assisting the steering movement, and a control unit (11) which controls the electric motor (9) as a function of the measured torque, and is designed to execute the method according to one of the preceding claims, wherein the control unit has capture timers that are designed to measure the actual switch-on and switch-off instants at the instant at which the Miller plateau is reached on the basis of rising and/or falling edges.

**8.** Electromechanical motor vehicle power steering according to claim 7, **characterised in that** the control unit (11) has an inverter which is designed to convert voltage signals into phase currents for controlling three motor phases of the electric motor (9), wherein each phase winding is assigned a half-bridge (14).

**9.** Electromechanical motor vehicle power steering system according to claim 7 or 8, **characterised in that** the switches (12, 13) of the half-bridges (14) are MOSFETs.

**Revendications**

**1.** Procédé de mesure du temps mort d'interrupteurs de puissance dans un étage de sortie de moteur, l'étage de sortie de moteur comprenant au moins un demi-pont (14) avec un FET côté haut (12) et un FET côté bas (13), les étapes suivantes étant prévues :

- mesure d'un instant d'activation réel et d'un instant de désactivation réel du FET côté bas (13),
- mesure d'un instant d'activation réel et d'un instant de désactivation réel du FET côté haut (12),
- comparaison des temps morts (DTF, DTR) avec des valeurs de consigne prédéfinies,
- détermination de l'écart entre les temps morts (DTR, DTF) et les valeurs de consigne prédéfinies,
- si l'écart est supérieur à une valeur prédéfinie, génération d'un signal d'erreur et/ou modification des commandes d'activation et de désactivation pour déterminer le temps mort,

**caractérisé en ce que** les temps morts sont calculés à l'aide des étapes suivantes :

- calcul de la durée entre une commande de coupure du FET côté haut (12) et le instant réel de mise en marche du FET côté bas (13) pour déterminer le temps d'activation du FET côté bas ($T_{ON\_L}$),
- calcul de la durée entre une commande de désactivation du FET côté bas (13) et le instant réel de désactivation du FET côté bas (13) afin de déterminer le temps de désactivation du FET côté bas ($T_{OFF\_L}$),
- Calculer la durée entre la commande de coupure du FET côté bas (13) et le instant réel de mise en marche du FET côté haut (12) afin de déterminer le temps d'activation du FET côté haut ($T_{ON\_H}$),
- Calculer la durée entre la commande de coupure du FET côté haut (12) et le instant réel de coupure du FET côté haut (12) afin de déterminer le temps de désactivation du FET côté haut ($T_{OFF\_H}$),
- Calcul des temps morts (DTF, DTR) à l'aide de la formule suivante :

DTF = (temps d'activation du FET côté bas ($T_{ON\text{-}L}$)) - (temps de désactivation du FET côté haut ($T_{OFF\text{-}H}$)),

DTR= (temps d'activation du FET côté haut ($T_{ON\text{-}H}$)) - (temps de désactivation du FET côté bas ($T_{OFF\text{-}L}$)),

les instants de désactivation réels et les instants d'activation étant définis dans la courbe de signal de la tension grille-source correspondante ($U_{GS}$) par le début respectif du plateau de Miller.

**2.** Procédé selon la revendication 1, **caractérisé en ce que** le procédé comprend la mesure des instants d'activation et de désactivation pour les valeurs positives et négatives du courant de puissance (I) circulant à travers le demi-pont et le calcul des temps morts s'effectue de manière correspondante pour les valeurs positives et négatives du courant de puissance (I) circulant à travers le demi-pont.

3. Procédé selon l'une des revendications précédentes, **caractérisé en ce que** la mesure des temps d'activation et de désactivation ($T_{ON-H}$, $T_{ON-L}$, $T_{OFF-H}$, $T_{OFF-L}$) est effectuée à l'aide d'un temporisateur de capture.

4. Procédé selon la revendication 3, **caractérisé en ce que** les temporisateurs de capture comportent un circuit de détection de flanc.

5. Procédé selon l'une des revendications précédentes, **caractérisé en ce que** la valeur prédéterminée est différente pour les valeurs négatives et positives de l'écart.

6. Procédé selon l'une des revendications précédentes, **caractérisé en ce que** la génération du signal d'erreur est suivie d'au moins l'une des étapes suivantes :

   - adaptation d'un intervalle d'entretien,
   - émission d'un signal au conducteur pour qu'il arrête le véhicule automobile,
   - émission d'un signal au conducteur pour qu'il se rende dans un garage, et/ou
   - passage du système de direction en mode défaut.

7. Direction assistée électromécanique pour véhicule automobile, comprenant un arbre de direction supérieur (3) relié à un volant (2) et un arbre de direction inférieur (4) relié à l'arbre de direction supérieur (3) par l'intermédiaire d'une barre de torsion, une unité de capteur de couple qui détecte un couple de mouvement de direction introduit par le conducteur dans l'arbre de direction supérieur (3), un moteur électrique (9) pour assister le mouvement de direction, et une unité de commande (11) qui commande le moteur électrique (9) en fonction du couple mesuré, et qui est conçue pour exécuter le procédé selon l'une des revendications précédentes, l'unité de commande comportant des temporisateurs de capture qui sont conçus pour mesurer les instants réels d'activation et de désactivation à l'instant où le plateau de Miller est atteint à l'aide de flancs montants et/ou descendants.

8. Direction assistée électromécanique pour véhicule automobile selon la revendication 7, **caractérisée en ce que** l'unité de commande (11) comprend un onduleur qui est conçu pour convertir des signaux de tension en courants de phase pour commander trois phases du moteur électrique (9), un demi-pont (14) étant associé à chaque enroulement de phase.

9. Direction assistée électromécanique pour véhicule automobile selon la revendication 7 ou 8, **caractérisée en ce que** les commutateurs (12, 13) des demi-ponts (14) sont des MOSFET.

**Fig. 1**

$U_{GS\_H}$

Phase

$U_{GS\_L}$

$U_{Phase}$

$U_{Bat}$

**Fig. 2**

Fig. 3

Fig. 4

**IN DER BESCHREIBUNG AUFGEFÜHRTE DOKUMENTE**

**In der Beschreibung aufgeführte Patentdokumente**

- EP 1876693 A1
- DE 102015115338 A1

- US 20060038545 A1